# EUROPEAN PATENT APPLICATION

(11) **EP 3 800 789 A1**
(43) Date of publication of application: **07.04.2021**
(21) Application number: 19201372.0
(22) Date of filing: 04.10.2019
(51) Int. Cl.: H03K 17/96

(54) **CAPACITIVE SENSOR SWITCH WITH SENSOR RING**

(71) Applicant: Captron Electronic GmbH, 82140 Olching (DE)
(72) Inventor: KALUS, Michael, 85221 Dachau (DE); RÜTH, Felix, 82140 Olching (DE); HÜTTENHOFER, Kilian, 81247 München (DE)
(74) Representative: Lohr, Jöstingmeier & Partner

(57) **Abstract**

A sensor switch comprises a housing with a touch surface and a printed circuit board holding a sensor ring spaced by legs. The sensor ring has a metal body forming a flat ring and at least two legs extending from the flat ring in an axial direction and the legs have equal lengths to hold the flat ring at a predetermined distance and parallel to the printed circuit board.

## Description

### Field of the invention

The invention relates to a capacitive sensor switch which may be used to detect the proximity of an object or body part like a hand to a sensing surface and a sensing and evaluation circuit thereof.

### Description of the related art

A touch sensitive switch is disclosed in EP 3 512 099 A1. Here, an AC signal is coupled into a sensor plate. An evaluation circuit measures the amplitude of the signal. If a human hand or another conductive object is placed into close proximity of the sensor plate, a capacitive current flows between the sensor plate and the hand, thus reducing the amplitude of the AC signal. The evaluation circuit may comprise a threshold detector and a window comparator to detect a certain change in amplitude and to issue a control signal at an output.

### Summary of the invention

The problem to be solved by the invention is to provide a capacitive proximity sensor providing a simple and robust mechanical and electrical design. Furthermore, the sensor should provide an increased sensitivity.

Solutions of the problem are described in the independent claims. The dependent claims relate to further improvements of the invention.

In an embodiment, a sensor switch comprises a housing which has a touch surface for operating the switch. The touch surface may be touched by a finger, a hand, or another body part of a person for operating the switch. For detecting the proximity of a body part, the sensor switch comprises a sensor ring arranged below the touch surface. The sensor ring is mounted to a printed circuit board further below the sensor ring, such that the sensor ring is between the printed circuit board and the touch surface. The printed circuit board comprises at least one electrical and/or electronic component. The printed circuit board generates an AC or RF signal which is fed into the sensor ring. A body part approaching the sensor switch and therefore the sensor ring has a capacitance which increases with decreasing distance. An increasing capacitance leads to an increasing AC or RF current flowing through the person which may be detected by the at least one electronic component and the printed circuit board. Such a detection may be based on an increasing AC or RF current through the sensor ring or a decreasing AC or RF voltage through the sensor ring.

The prior art of EP 3 512 099 A1 uses a comparatively solid sensor electrode having only minimal gaps for lighting and signaling, to provide a high coupling capacitance and therefore a strong sensor signal towards the body part at the outside of the switch. The embodiment of the sensor ring is based on a different approach. When considering a sensor electrode of a capacitive sensor switch in general, there is a first sensor capacitance between the sensor electrode and the person or the body part to be sensed. Furthermore, there is a parasitic capacitance between the sensor electrode and the environment. Such a parasitic capacitance cannot be avoided and it leads to an additional voltage drop at the sensor electrode or a current flowing through the sensor electrode. This additional signal can normally not be distinguished from a signal through a person or a body part approaching a sensor electrode.

The embodiments are based on the finding that a sensor electrode can be reduced in its size as long as the parasitic capacitances are also reduced.

In an embodiment, the sensor ring comprises a flat ring of metal which has at least two legs extending from the flat ring in an axial direction such that the flat ring can be mounted to the printed circuit board by the legs in a position spaced from the printed circuit board. If the legs are attached, e.g. by soldering to the surface of the printed circuit board, the distance between the printed circuit board and the flat ring is the length of the legs. If the legs penetrate the printed circuit board, for example through through-holes which may result in an improved fixation, an additional length of the legs may be required. Preferably, the legs have lengths, matched such that the flat ring is positioned parallel to the printed circuit board. For this purpose, it is further preferred if the legs have the same length. Basically, two legs may be sufficient, but it may be preferred to have a higher number of legs, for example three or four legs to improve stability. Such an electrode, preferably with SMD (Surface Mounted Device) pads at the ends of the legs may be automatically placed at the PCB with a standard PCB pick and place machine.

Placing the ring distant from the PCB (Printed Circuit Board) on legs provides another advantage, as the space requirements on the PCB are minimal and therefore more space for electronic components or signaling components is available.

By positioning the flat ring in a distance to the printed circuit board, the parasitic capacitance to the environment to which also a ground plane on the printed circuit board counts, is minimized. Furthermore, it is beneficial if the ring is essentially flat, because this reduces the capacitance in a radial direction of the ring to the environment. For example, the switch may be mounted to a metal frame or metal housing of some device, such that there will also be a parasitic capacitance between the internal components of the switch and the metal parts of the environment. A reduced cross-section sideward or projected into a radial direction would reduce such a parasitic capacitance. Therefore, the flatter the ring, the smaller is the parasitic capacitance. To obtain good results, the flat ring may comprise thin metal having a thickness between 0.1 mm and 1 mm, preferably between 0.3 mm and 0.5 mm. To obtain a good sensor capacitance, the ring should have a certain width, which is the area projected to the touch surface. The width may be determined by the difference between the outer diameter and the inner diameter. Basically, the ring must not be a precise circular ring. It may also have the shape of an approximated circle, like a polygon or any other similar shape. Furthermore, the outer contour may be different from the inner contour. For example the outer contour may be a circle, whereas the inner contour is a polygon. The ring provides a free opening which may be used for lighting, and/or indicating states, and/or displaying values. The opening may on one hand be adapted to provide a sufficient sensor area, and on the other hand to provide an opening large enough for a LED, a display or any other indication means. In general it is preferred, if the width of the flat ring is larger than the thickness of the flat ring. It is preferred, if the ratio of its width to its thickness is more than at least one of 2:1, 3:1, 5:1, 10:1. In an embodiment, the diameter of the ring which may either be the inner diameter or the outer diameter, is somewhat larger than the width of a finger of a person operating the switch which may be assumed with approximately 2.5 cm. Therefore, it is preferred to have a maximum inner diameter of the ring of 2.5 cm.

In a further embodiment, the flat ring has at least one curved edge. The term curved edge means that the edge has a curved shape or may have a bulged shape. This increases stability of the flat ring. The flat ring may have a curved inner edge and/or a curved outer edge.

The flat ring may be made of a punched or a laser-cut sheet metal. This allows simple and cost-efficient manufacturing of the flat ring.

In an embodiment, the legs may be equally spaced around the flat ring. Furthermore, the legs may comprise at least one of a rod, a wire, or a metal plate.

In an embodiment, at least one of the legs may comprise a solder pad at an end of the leg which is distant of the flat ring, such that the leg may be soldered to the printed circuit board.

In another embodiment, at least two of the legs are electrically connected, e.g. soldered to the printed circuit board. Furthermore, the printed circuit board comprises a test circuit, which is configured to measure the electrical characteristic between at least two of the legs electrically connected to the printed circuit board. As the legs are also one part with the flat ring or are at least connected to the flat ring, there is a closed current path from a first of the legs through the flat ring back through a second of the legs. If there is a good electrical connection between the legs, the printed circuit board, and the flat ring, a low impedance or high conductivity can be measured, which indicates good connections. For example, if one of the solder connections fails, there is a poor contact, which may also be detected. Therefore, in this embodiment, a good electrical and mechanical contact between the flat ring and the printed circuit board can easily be verified.

In a further embodiment, the printed circuit board and the sensor ring may be casted into the housing or a part of the housing.

### Description of Drawings

In the following the invention will be described by way of example, without limitation of the general inventive concept, on examples of embodiment with reference to the drawings.
- Figure 1: shows a capacitive sensor switch in a perspective view.
- Figure 2: shows a sectional view of a sensor switch.
- Figure 3: shows a top view of the sensor switch.
- Figure 4: shows details of the sensor ring.
- Figure 5: shows a sensor switch circuit assembly is shown.
- Figure 6: shows a mounted sensor switch.
- Figure 7: shows a basic electrical diagram of the sensor switch.

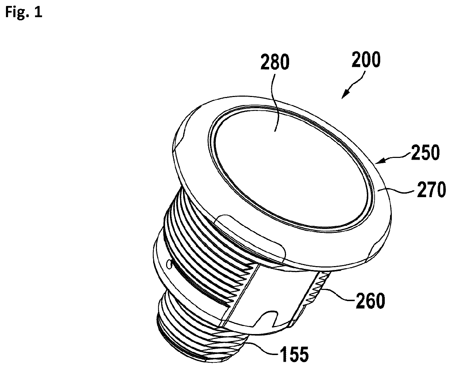

In Figure 1, a capacitive sensor switch 200 is shown in a perspective view. The sensor switch 200 has a housing 250 with a touch surface 280. The touch surface 280 may be surrounded by the decorative ring 270 which may also increase stability. There may be a housing thread 260 at the housing 250, by which the sensor switch may be mounted to any surface. At the bottom of the sensor switch (opposing to the touch surface 280), a connector or a connector thread 155 is shown.

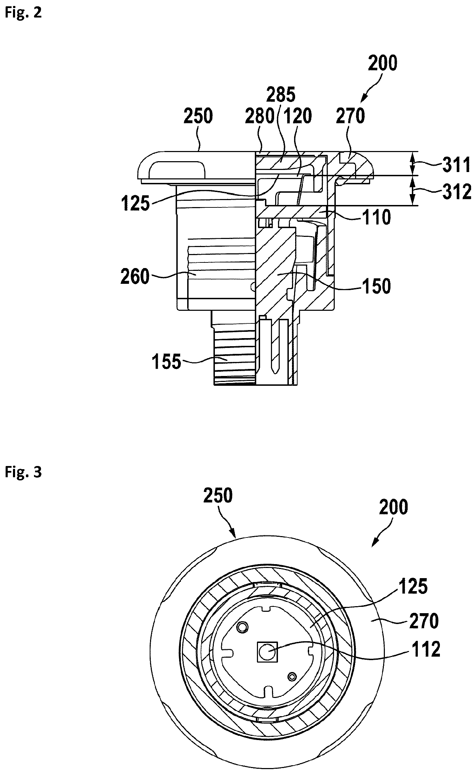

In Figure 2, a sectional view of a sensor switch 200 is shown. The sensor switch 200 comprises a printed circuit board 110 holding a sensor ring 120. In this Figure, further the spatial relationships between the flat ring 125 of the sensor ring 120 and the touch surface 280 as well as the printed circuit board 110 is shown. There is a first distance 311 between the touch surface 280 and the flat ring 125. A second distance 312 is between the flat ring 125 and the printed circuit board 110. Preferably, the first distance is smaller than the second distance to obtain a good signal by low parasitic capacitance. Under the touch surface 280, there may for example be a lens 185 for focusing light from the LED.

In Figure 3, a top view on the sensor switch 200 is shown. Here, the flat ring 125 can be seen surrounding an LED 112 which may be at the center of the printed circuit board.

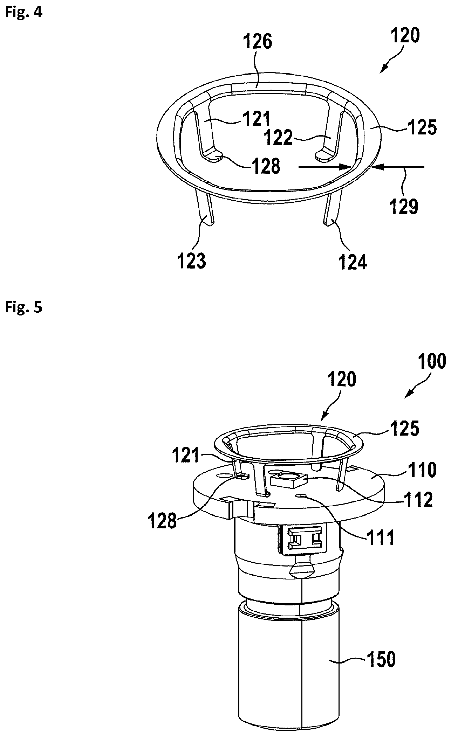

In Figure 4, details of the sensor ring 120 are shown. The sensor ring 120 comprises a flat ring 125 which may have a curved inner edge 126. There may also be a curved outer edge which is not shown. In this embodiment, the sensor ring 120 comprises four legs 121, 122, 123, and 124 which are equally spaced in this embodiment. The legs 121 and 122 also have solder pads 128 which simplify soldering of the sensor ring to a printed circuit board. It is not necessary to solder all legs to the printed circuit board, as some of the legs may simply stand on the printed circuit board. The thickness of the ring is indicated by 129.

In Figure 5, a sensor switch circuit assembly 100 is shown. It is based on a printed circuit board 110 which comprises at least one electronic component 111, and which may further comprises an LED 112. This LED may be for lighting of the sensor switch and/or for indicating states of the sensor switch. On the printed circuit board 110, a sensor ring 120 is mounted. Here it can be seen, that the flat ring 125 of the sensor ring 120 is distant from the printed circuit board, and therefore provides a low parasitic capacitance thereto. At the bottom of the printed circuit board, there is an electrical connector 150 which may be any type of a suitable connector.

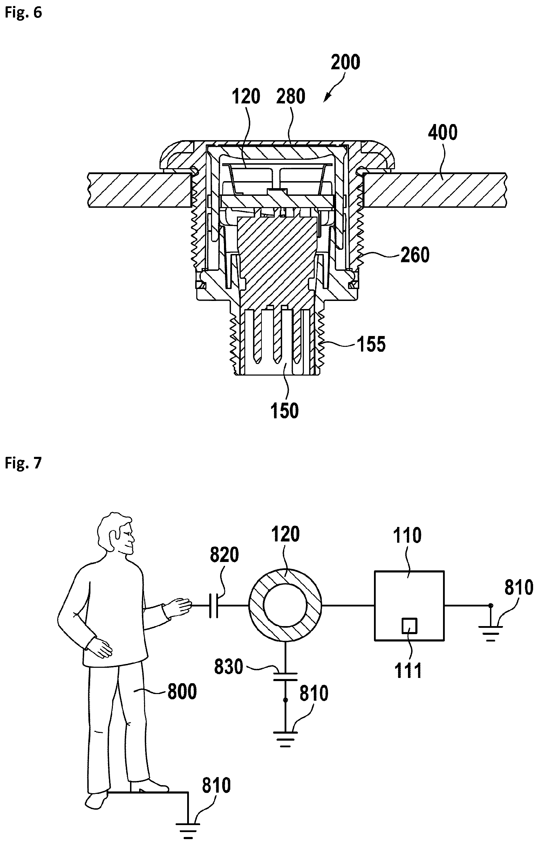

In Figure 6, a sensor switch mounted to a metal frame 400 is shown. Here it can be seen, that the flat ring 125 of the sensor ring 120 has only a very low parasitic capacitance due to its flat shape.

In Figure 7, a basic electrical diagram of the sensor switch is shown. The devices of a printed circuit board 110 produce an AC or RF signal which is fed to the sensor ring 120. A person 800 approximating the sensor switch has a sensor capacitance 820 to the sensor switch which leads to a voltage drop or current flow through the sensor ring to ground 810 on which the person stands. To function properly, the sensor electronic on the printed circuit board 110 must also refer to ground 810. Due to the mechanical properties of the sensor switch, there is a parasitic capacitance 830 between the sensor ring 120 and the ground. The basic concept of the invention is to provide a comparatively high sensor capacitance to parasitic capacitance ratio, instead of providing an absolute high sensor capacitance 820.

### List of reference numerals

- 100: sensor switch circuit assembly
- 110: printed circuit board
- 111: electronic component/test circuit
- 112: LED
- 120: sensor ring
- 121 - 124: leg (feet)
- 125: flat ring
- 126: curved inner edge
- 128: solder pad
- 129: thickness of ring
- 150: electrical connector
- 155: connector thread
- 200: sensor switch
- 250: housing
- 260: housing thread
- 270: ring
- 280: touch surface
- 285: lens
- 311: distance between the touch surface and the flat ring
- 312: distance between the flat ring and the printed circuit board
- 400: metal frame
- 800: person
- 810: ground
- 820: sensor capacitance
- 830: parasitic capacitance

## Claims

1. A sensor switch (200) comprising a housing (250) with a touch surface (280) and a printed circuit board (110) held within the housing (250), **characterized in, that**
a sensor ring (120) which is mounted to the printed circuit board (110) is arranged between the touch surface (280) and the printed circuit board (110),
the printed circuit board (110) comprises at least one electronic component (111) connected to the sensor ring (120),
the sensor ring (120) has a metal body forming a flat ring (125) and at least two legs (121, 122, 123, 124) extending from the flat ring (125) in an axial direction and the legs have matched lengths to hold the flat ring (125) at a predetermined distance to the printed circuit board (110).

2. The sensor switch (200) according to claim 1,
**characterized in, that**
the flat ring (125) has a width larger than its thickness.

3. The sensor switch (200) according to the previous claim,
**characterized in, that**
the flat ring (125) has a ratio of its width to its thickness of more than at least one of 2, 3, 5, 10.

4. The sensor switch (200) according to any of the previous claims, **characterized in, that**
the flat ring (125) has a curved inner edge (126) and/or a curved outer edge.

5. The sensor switch (200) according to any of the previous claims, **characterized in, that**
the flat ring (125) is parallel to the printed circuit board (110).

6. The sensor switch (200) according to any of the previous claims, **characterized in, that**
the sensor ring (120) comprises punched and/or laser cut sheet metal.

7. The sensor switch (200) according to any of the previous claims, **characterized in, that**
the at least two legs (121, 122, 123, 124) are equally spaced around the flat ring (125).

8. The sensor switch (200) according to any of the previous claims, **characterized in, that**
at least one of the legs (121, 122, 123, 124), comprises at least one of a rod, a wire, a metal plate.

9. The sensor switch (200) according to any of the previous claims, **characterized in, that**
at least one of the legs (121, 122, 123, 124) comprises a solder pad (128) at an end of the leg distant from the flat ring (125).

10. The sensor switch (200) according to any of the previous claims, **characterized in, that**
at least two legs (121, 122, 123, 124) are electrically connected to the printed circuit board (110) and
the printed circuit board (110) comprises a test circuit (111) which is configured to measure the electrical characteristic between at least two of the electrically connected legs.

11. The sensor switch (200) according to the previous claim,
**characterized in, that**
the test circuit (111) indicates the presence of the sensor ring (120) based on the measured resistance and/or conductivity.

12. The sensor switch (200) according to any of the previous claims, **characterized in, that**
a light emitting diode (112) is arranged at the printed circuit board (110) and centered to the ring (270).

13. The sensor switch (200) according to any of the previous claims, **characterized in, that**
the sensor ring (120) is covered by a dielectric housing part, separating the sensor ring (120) from a touch surface (280), wherein the distance (311) between the touch surface (280) and the flat ring (125) may be less than the distance (312) between the flat ring (125) and the printed circuit board (110).

14. The sensor switch (200) according to any of the previous claims, **characterized in, that**
the printed circuit board (110) and the sensor ring (120) are casted into the housing (250) or a part thereof.
